# EUROPEAN PATENT APPLICATION

(11) **EP 1 528 407 A1**
(43) Date of publication of application: **04.05.2005**
(21) Application number: 03256922.0
(22) Date of filing: 31.10.2003
(51) Int. Cl.: G01S 13/04, G04F 10/06

(54) **Decomposition of a wideband random signal**

(71) Applicant: Mitsubishi Electric Information Technology Centre Europe B.V., Guildford, Surrey GU2 5YD (GB); MITSUBISHI DENKI KABUSHIKI KAISHA, Tokyo 100 (JP)
(72) Inventor: Szajnowski, Wieslaw Jerzy, Guildford Surrey, GU1 1AR (GB)
(74) Representative: Burke, Steven David

(57) **Abstract**

A wideband random signal is decomposed into respective frequency bands, the ratio of the highest to the lowest frequency within each band being in the ratio of approximately 3:1. The wideband signal, or a re-constituted wideband signal formed by combining the decomposed components, is transmitted as a interrogating signal. A reflection of the interrogation signal is decomposed into respective frequency bands, and within each frequency bands the different components are compared. The results of the comparisons are combined to determine whether an object has been detected and, if so, its range. Decomposition of the wideband signal can be achieved by using a bank of low-pass filters in respective frequency bands, the output of each low-pass filter having subtracted therefrom the output from the filter with the next-lower frequency cut-off characteristic. Delay circuits are used within each channel so that the total delays in each individual channel are equal.

## Description

### FIELD OF THE INVENTION

This invention relates to a method and apparatus for decomposing and representing a wideband random signal by a plurality of component random signals, each component signal occupying a frequency band narrower than that of the primary random signal, and is particularly but not exclusively applicable to an object-sensing device operating within a radio or microwave frequency range and utilizing a wideband random signal to interrogate a surveillance region of interest.

### BACKGROUND OF THE INVENTION

In a broad class of active surveillance systems, the presence of an object of interest in a region being interrogated is determined from the observed differences between a transmitted wideband random signal and a received signal reflected by various scatterers present in the region. In general, the characteristics of the received backscattered signal depend on the properties of scatterers, such as their reflectivity, location, relative movement etc. Therefore, the backscattered signal can contain useful information about the interrogated region, especially when the frequency range of a transmitted random signal has been chosen in a judicious way.

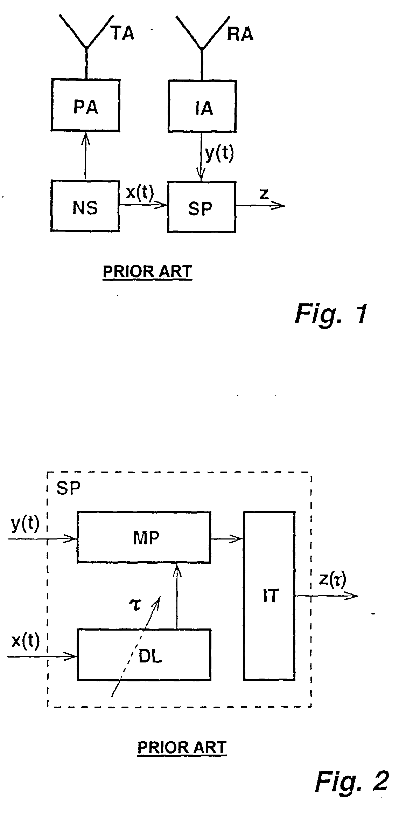

One example of a surveillance system is shown in Fig. 1 which depicts a block diagram of a simple sensing device operating in the foliage penetration frequency band, extending from 50 MHz to 600 MHz. The device comprises a wideband noise source NS, a power amplifier PA, a transmit antenna TA, a receive antenna RA, an input amplifier IA, and a signal processor SP that processes jointly a copy of a transmitted signal x(t) together with a received signal y(t) to produce a response z containing information about the reflectivity and locations of various scatterers. The range resolution of the system is limited by a 600-MHz frequency component of a transmitted random signal; hence, the range resolution is equal approximately to 0.25m.

The signal processor SP used by the system may, for example, employ a conventional wideband crosscorrelator whose block diagram is shown in Fig. 2. The crosscorrelator comprises a variable delay line DL driven by a copy of a transmitted random signal x(t), a suitable multiplier MP whose one input is connected to the output of the delay line DL, while its other input is driven by a received signal y(t), and a finite-time integrator IT operating on the output of the multiplier MP and producing an output value z indicative of the reflectivity of the interrogated region. In particular, as the delay value τ of the variable delay line DL is changing slowly and continually, the output of the integrator IT traces out a curve z(τ) representing the observed reflectivity versus distance (from the system). For example, time delays varying from 1µs to 10µs will correspond to distances ranging from 150m to 1.5km.

In some correlator systems, the operations performed by the multiplier MP and the integrator IT are carried out, respectively, by a radio-frequency mixer and a suitable low-pass filter.

Alternatively, in order to detect an object and determine its range, the signal processor SP of Fig. 1 may employ a method disclosed in U.S. Pat. No. 6,539,320. In the following, the disclosed method will be referred to as "crosslation", and a system implementing the method will be referred to as a "crosslator". The contents of U.S. Pat. No. 6,539,320 are incorporated herein by reference.

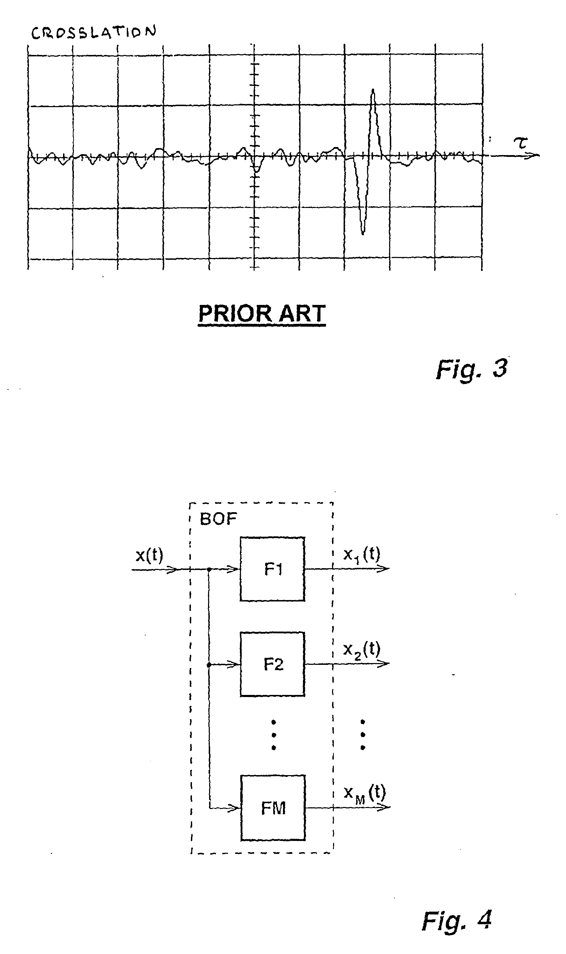

According to the above disclosure, a random signal x(t) is subjected to an unknown delay to produce a signal y(t), and a reference version of the signal x(t) is examined to determine the time instants at which its level crosses zero with a positive slope (an *upcrossing).* The time instants of these upcrossing events are used to obtain respective segments of the signal y(t), the segments having a predetermined duration. The segments are all summed, and a representation of the summed segments is then examined to locate a feature in the form of an S-shaped odd function. In the following, the S-shaped odd function will be referred to as the *crosslation* function. The position within the representation of a zero-crossing in the centre of the crosslation function represents the amount by which the signal has been delayed. Fig. 3 shows an example of an S-shaped crosslation function obtained experimentally by processing a wideband noise signal.

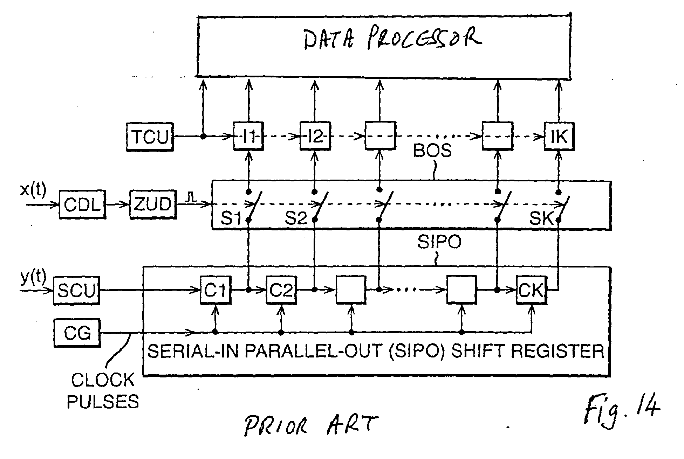

Fig. 14 shows one possible example of time delay discriminator, for example for use in an object detection system, which operates using these techniques. The analogue signal y(t) supplied by the demodulator is the sum of noise n(t) and the transmitted random signal x(t) that has been attenuated by the factor of a and delayed by Δt; hence$\text{y(t) = a.x(t - Δt) + n(t).}$

The signal y(t) is converted by a signal conditioning unit (SCU) into a suitable (analogue or digital) form and then applied to the input of a serial-in parallel-out (SIPO) shift register.

The SIPO shift register consists of K storage cells, Cl, C2...., CK. Each cell has an input terminal, an output terminal and a clock terminal. The cells are connected serially so that each cell, except for the first one (Cl) and the last one (CK), has its input terminal connected to the output terminal of a preceding cell and its output terminal connected to the input terminal of a succeeding cell. The input terminal of cell Cl is used as the serial input of the SIPO shift register. The output terminals of all K cells are the parallel output terminals of the SIPO shift register. All clock terminals of the cells are connected together to form the clock terminal of the SIPO shift register.

A sequence of suitable clock pulses is provided by a clock generator CG. When at time instant to a clock pulse is applied to the clock terminal of the SIPO shift register, the datum stored in each cell is transferred (shifted) to and stored by the succeeding cell; cell Cl stores the value y(t₀) of the input signal y(t).

The shift register can be implemented either as a digital device or an analogue device, for example, in the form of a bucket-brigade charge-coupled device (CCD). Preferably, the SIPO shift register will consists of binary flip-flops. Preferably, the input terminal of this register will be driven by a suitable binary two-level waveform supplied by the signal conditioning unit (SCU) which may comprise a hard limiter. A hard limiter has a step-like transfer function such that a variable-amplitude input is transformed into a two-level output.

The parallel outputs of the SIPO shift register are connected through a bank BOS of K switches (S1, S2,... , SK) to K averaging or integrating units, I1, I2, ... , IK, that accumulate data supplied by the SIPO shift register. The switches, normally open, are closed when a suitable signal is applied to their control input. The time interval during which the switches are closed should be sufficiently long so that each new incremental signal value can be acquired with minimal loss. The time instants, at which the switches are closed and new data supplied to the integrating units, are determined by a zero upcrossing detector (ZUD) that detects the upcrossings of zero level of the reference random binary signal x(t) delayed by a constant-delay line CDL. Thus asynchronous operation is achieved. The value of the constant delay is equal to or greater than the expected maximum value Δtmax of time delay to be determined. It should be noted that the integrators receive the incremental input values from the SIPO shift register in non-uniform manner, at the time instants coinciding with zero upcrossings of the delayed reference signal x(t).

Each time a zero upcrossing occurs, there appears transiently on the integrator inputs a representation of a respective segment of the signal y(t). The integrators thus combine these segments to produce a representation of a combined waveform, like that of Fig. 3.

The timing control unit (TCU) determines the data transfer rate to the data processor 11 by initiation and termination of the averaging or integration processes performed by the K integrators 11, 12,... , IK. The averaging or integrating functions may be implemented either as a moving or standard average with initial value zero. These may be circumstances in which weighting is desirable, i.e. wherein the averages are weighted averages.

The signals obtained at the outputs of the integrators I1, I2,... , IK are used by the data processor. The operations performed by the data processor can be summarised as follows, and can be implemented easily by anyone skilled in the art:
- two suitable thresholds are used to detect the two peak values (a maximum and a minimum) of the implicit average, exploiting the fact that the peak separation is substantially known;
- the time delay from the location of the zero crossing situated between these two peaks of opposite polarity is determined;
- in an object detection system, the distance to the obstacle is determined from this time delay.

The data processor may also determine the velocity of the obstacle from the change of distance with time.

Instead of using upcrossings, the reference version of a wideband signal x(t) could be examined to determine the time instants at which its level crosses zero with a negative slope *(downcrossings).* U.S. Pat. No. 6,539,320 also suggests improving accuracy by using both upcrossings and downcrossings. In such a case, the crosslation function to be determined is obtained by summing segments defined by upcrossings and subtracting those defined by downcrossings.

Irrespective of the particular arrangement used, a crosslation-based technique always includes a step of determining the time instants at which a reference signal crosses a predetermined threshold. In the following, those specific time instants will also be referred to as *significant events.*

Significant events, associated with upcrossings and/or downcrossings, are used to extract respective segments of a received composite signal y(t), which, in general, contains two types of components:
- a plurality of delayed and attenuated replicas of a transmitted wideband random signal x(t) reflected by various objects present in the interrogated region;
- noise, interference, and other unwanted signals not related in any way (functionally or statistically) to the transmitted random signal x(t).

Detectability of an object-reflected signal in noise and other interfering signals depends on both the object's reflectivity and the ability of a signal processor, such as correlator or crosslator, to suppress those unwanted signals. Owing to the fact that unwanted signals are not related functionally or statistically to a transmitted random signal x(t), the efficacy of interference suppression will increase with the number of averaged quantities influenced by a received signal y(t).

When a crosslation technique is used, the number of averaged segments of a received signal y(t) is determined by the number of significant events extracted from a transmitted random signal x(t). Therefore, it would be desirable to determine an optimum number of signal segments of y(t) which need to be averaged in time T to provide maximum interference suppression.

It is known, by the sampling theorem, that a wideband random signal is completely determined by its samples taken uniformly at time instants separated by the interval 1/(2W), where W is the highest frequency component of the signal's power spectrum. This result is often stated that a noise waveform of duration T contains Λ = 2WT *degrees of freedom.*

In signal processing applications, the product Λ is also referred to as the *processing gain,* because it indicates the bound on the achievable reduction of noise power by averaging uncorrelated samples of a respective noise waveform. It is also known that the above results apply to cases when a noise waveform is sampled in a nonuniform manner, yet with the *mean* sampling rate of 2W samples per second.

From the above discussion it follows that the ability of a crosslator to suppress unwanted interference can be degraded when the number of significant events extracted from a transmitted wideband signal x(t) is less than Λ. This conclusion will be explained in more detail by way of the following example.

### Example 1

Assume that a received signal y(t) contains an interfering signal n(t) with a uniform power spectral density, band-limited to the frequency range (0, W); hence, the number of degrees of freedom in time T is Λ = 2WT. Consequently, by averaging, it is possible to reduce the interfering signal power by a factor of Λ.
Suppose also that a zero-mean Gaussian random signal x(t), used for surveillance purposes, has a uniform power spectral density band-limited to (0, W). From Rice's formula, it follows that the expected number of all zero crossings contained in x(t) in time T is equal to N₀(T) = 2TBₓ, where Bₓ = W/√(3) is the root-mean-square (rms) bandwidth of x(t); hence, N₀(T) = 2WT/ √(3) < Λ. Because each zero crossing determines exactly one segment of a received signal y(t) to be averaged, the power of the interfering signal n(t) will be reduced by only a fraction, 1/ √(3) ≈ 0.58, of the maximum achievable value Λ.

From the above discussion it follows that crosslation-based techniques disclosed in the cited Patent document cannot provide optimum-efficiency suppression of interference, because the number of significant events extracted from a transmitted random signal x(t) is, in general, less that the number of degrees of freedom contained in an unwanted interfering signal n(t).

Accordingly, it would be desirable to provide a technique for enabling improved range resolution and interference suppression. The resulting improved technique may, for example, be employed in a surveillance system operating in a radio or microwave frequency range and utilizing a wideband random signal for object detection and localisation.

### DESCRIPTION OF THE INVENTION

Aspects of the present invention are set out in the accompanying claims.

According to a further aspect of the invention, a wideband random signal is decomposed into channels containing different frequency bands in such a way that the channels collectively exhibit significantly more zero crossings than the original wideband signal.

As shown in: I. J. Good, The Loss of Information due to Clipping a Waveform. *Information and Control.* **10,** 220-222 (1967), the contents of which are incorporated herein by reference, zero crossings of a noise waveform can provide a sufficient number of degrees of freedom, when the power spectral density of noise is uniform in the frequency band (W₁, W₂), vanishes outside that band, and W₁ is no less than${\text{W}}_{\text{1} \text{min}} \text{=} \frac{{\text{4W}}_{\text{2}}}{\text{7} \text{+} \sqrt{\text{33}}} \text{≈} {\text{0.3739 W}}_{\text{2}}$

Therefore, when W₁ < W₁_{*min*}, the power of the interfering component n(t) present in the received signal y(t) will be reduced by *less* than the maximum achievable value of the processing gain Λ = 2(W₂ - W₁)T.

Accordingly, it is desirable for the ratio of the highest frequency to the lowest frequency within each frequency band to be approximately 1/0.3139:1, i.e. approximately 3.19:1. This figure varies for non-uniform (e.g. Gaussian) spectral densities, but nevertheless for a signal of practical value will be approximately 3:1 or slightly greater. In the present invention, generally it is preferable for this ratio to be in the range of 2.5:1 to 3.5:1 to allow for optimum, or near-optimum, efficiency. A smaller ratio will result in the need for a greater number of channels, leading to redundancy and inefficiency (although in certain circumstances the redundancy may be desirable). A larger ratio will result in fewer zero crossings and thus significantly reduced efficiency.

According to a further aspect of the present invention, a primary wideband random signal x(t) is decomposed into a number M of component random signals, x₁(t), x₂(t), ... , x_{M}(t), in such a manner that:
- each component random signal will occupy a frequency band narrower than that of the primary random signal;
- the component random signals will *collectively* provide a substantially increased number of zero crossings, preferably no less than the number of degrees of freedom contained in the primary wideband random signal x(t);
- the component random signals will *collectively* provide a number of zero crossings no less than the number of degrees of freedom contained in an unwanted interfering signal to be suppressed;
- the component random signals can be suitably combined to reconstitute the primary wideband random signal x(t).

The invention extends to methods and apparatus for decomposing wideband signals, to methods and apparatus for the investigation of signals, or pairs of signals, using such decomposition techniques, and to methods and apparatus for object detection using such investigation techniques.

### DESCRIPTION OF THE DRAWINGS

Arrangements embodying the invention will be described by way of example with reference to the accompanying drawings.

Fig. 1 is a block diagram of a simple sensing device operating in the radio frequency band.

Fig. 2 is a block diagram of a conventional wideband crosscorrelator.

Fig. 3 shows an example of an S-shaped crosslation function obtained experimentally by processing a wideband noise signal.

Fig. 4 depicts a block diagram of a bank of filters performing decomposition of a primary wideband random signal, according to the invention.

Fig. 5 shows a relationship between the rectangular spectrum of a primary wideband random signal and the rectangular power transfer functions of the three bandpass filters used for signal decomposition, according to the invention.

Fig. 6 shows an M-channel binary component resolver arranged to operate according to the invention.

Fig. 7 is a block diagram of an object detection system arranged to operate in accordance with the present invention.

Fig. 8 depicts the required power spectral density (solid line) obtained by subtracting the frequency-scaled Gaussian spectrum from the primary Gaussian spectrum (broken lines).

Fig. 9 shows the required impulse response (solid line) and its approximation (broken line).

Fig. 10 is a block diagram of a basic bandpass cell of a bank of filters, arranged to operate in accordance with the invention.

Fig. 11 shows examples of a primary wideband random signal and a resulting bandpass component random signal obtained experimentally by applying a wideband noise signal to the basic bandpass cell, constructed in accordance with the invention.

Fig. 12 depicts a block diagram of a bank of filters comprising a plurality of basic bandpass cells, arranged to operate in accordance with the present invention.

Fig. 13 depicts a block diagram of a modified bank of filters comprising a plurality of basic bandpass cells, arranged to operate in accordance with the present invention.

Fig. 14 is a block diagram of a time delay determining system using crosslation techniques.

Fig. 15 is a block diagram of another object detection system arranged to operate in accordance with the present invention.

### DETAILED DESCRIPTION OF A PREFERRED EMBODIMENT

Fig. 4 depicts a block diagram of a bank of filters BOF performing decomposition of a primary wideband random signal x(t) according to the invention. The bank BOF comprises a plurality of bandpass filters, F1, F2, ... , FM, sharing a common input driven by a primary signal x(t) to be decomposed. Each filter Fm, m = 1, 2, ... , M, of the bank BOF has a rectangular power transfer function |Hₘ(f)|², and the filters jointly and contiguously cover the frequency band (W₁,W₂) occupied by the input signal x(t). By construction, when the transfer function Hₘ(f) (or, equivalently, the impulse response) of each filter of the bank BOF has been specified, the resulting component random signals, x₁(t), x₂(t), ... , x_{M}(t), will represent jointly the input wideband random signal x(t) in a unique way. It should be also noted that the component random signals are mutually independent, because their power spectra do not overlap.

When the power spectral density of a component signal xₘ(t) is uniform, the number of zero crossings occurring in that signal (observed at the output of filter Fm) will be equal to (or greater than) the number of degrees of freedom contained in that signal, if the ratio of the upper cut-off frequency to the lower cut-off frequency for filter Fm, is equal to (or less than) 1/0.3139 ≈ 3.19 (as shown in Example 1).

When the power spectral density of a primary wideband random signal x(t) to be decomposed is uniform in the frequency band (W₁, W₂) and vanishes outside that band, the required number M of filters used by the bank BOF will depend on the ratio R_{UL} = W₂ / W₁, as shown in Table 1 below.

**Table 1**

| R_{UL} | M |
|---|---|
| R_{UL} ≤ 3.19 | 1 |
| 3.19 < R_{UL} ≤ 10.15 | 2 |
| 10.15 < R_{UL} ≤ 32.33 | 3 |

In practical applications, the value of the ratio R_{UL} will rarely exceed 32. For example, in order to detect various complex objects, an interrogating signal will have to contain frequency components ranging from 30 MHz to 960 MHz (hence, R_{UL} = 32), as stated in: Guo-Sui Liu *et al.,* Random Signal Radar, *IEEE Transactions on Aerospace and Electronic Systems.* **39**, 489-498 (April 2003),

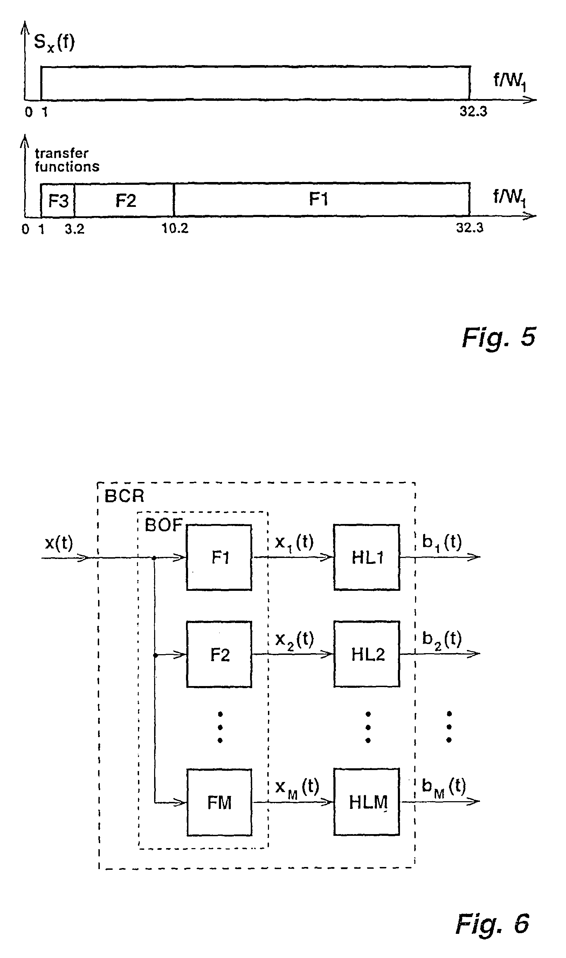

For illustrative purposes, Fig. 5 shows schematically the relationship between the rectangular spectrum Sₓ(f) of a primary wideband random signal x(t) and the power transfer functions of three bandpass filters, F1, F2 and F3 used for signal decomposition. It should be noted that a first component signal x₁ (t) contains about 67% of the total power of the primary signal x(t).

When a primary wideband random signal x(t) is strictly a low-pass signal (i.e. its power spectral density extends to zero, hence W₁ = 0), the number M of required bandpass filters will *theoretically* tend to infinity, and the bank of filters BOF will adopt a 'fractal' structure. However, in practice, the M-th filter of the bank BOF can be replaced by a low-pass filter. In such a case, when only three filters (M = 3) are used, the loss in the number of degrees of freedom will be less than 4.2%, and for four filters (M = 4), this loss reduces further to about 1.3%. Therefore, in most practical applications, the number M of bandpass filters employed by the bank BOF for signal decomposition will be limited to three or four, irrespective of the spectral width of a wideband random signal x(t) to be decomposed.

According to a preferred aspect of the invention, each bandpass filter Fm of the bank BOF is followed by a respective hard limiter HLm to form an M-channel binary component resolver BCR whose block diagram is depicted in Fig. 6. As a result, each component random signal xₘ(t) is converted into a corresponding random binary waveform bₘ(t), and a primary wideband random signal x(t) is represented *collectively* by M random binary waveforms, b₁(t), b₂(t), ... , b_{M}(t). From mutual independence of component random signals it follows that the resulting random binary waveforms are also mutually independent.

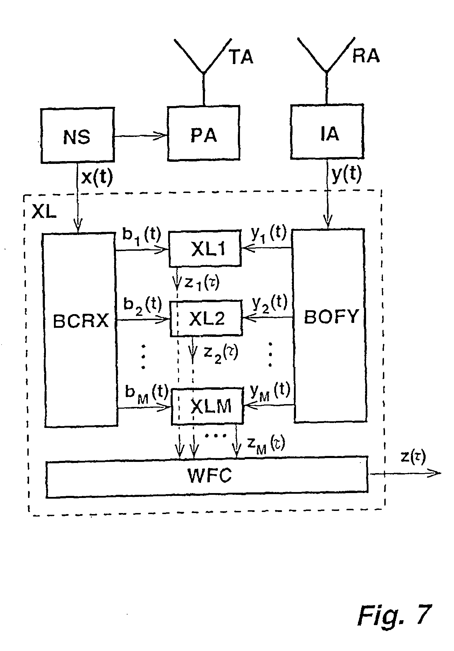

An M-channel binary component resolver and a bank of filters, arranged in accordance with the present invention, can be used to construct an improved crosslator XL to be employed as a signal processor SP by a sensing device of Fig. 1. A block diagram of a resulting system is depicted in Fig. 7. The system comprises a wideband noise source NS with flat spectrum, a power amplifier PA, a transmit antenna TA, a receive antenna RA, an input amplifier IA, an M-channel binary component resolver BCRX, a bank of M filters BOFY, M crosslators, XL1, XL2, ... , XLM (each of which could have the structure shown in Fig. 14), and a waveform combiner WFC. In some specific applications, the system can be modified by replacing the bank of filters BOFY by a suitable M-channel binary component resolver.

A copy of a wideband random transmitted signal x(t) with flat spectrum is decomposed by the binary component resolver BCRX into M respective random binary waveforms, b₁(t), b₂(t) and b_{M}(t). Each crosslator XLm, m = 1, 2, ... , M, extracts significant events from a respective binary waveform bₘ(t) to average segments of a corresponding received component signal yₘ(t) supplied by filter Fm of the bank BOFY. As a result, each crosslator XLm produces a partial response zₘ(τ). All the partial responses are then suitably combined in the waveform combiner WFC to provide a global response z(τ) containing information about the reflectivity and locations of various scatterers present in the region examined by the sensing system. When only a single reflecting object is present in the region, the global response z(τ) will assume the form of an S-shaped curve, representing the crosslation (similar to that shown in Fig. 3).

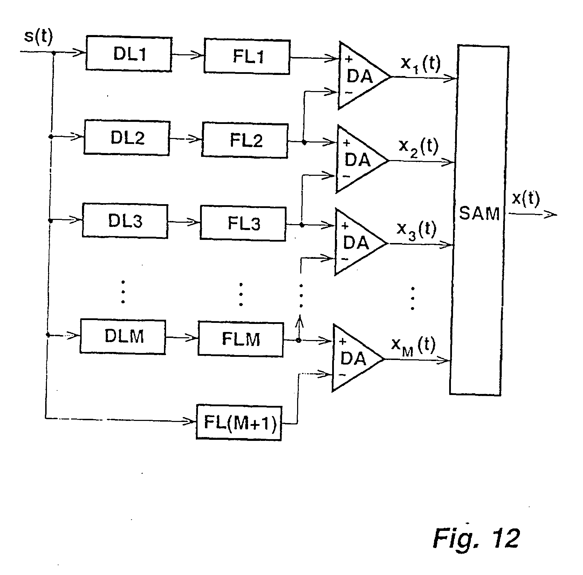

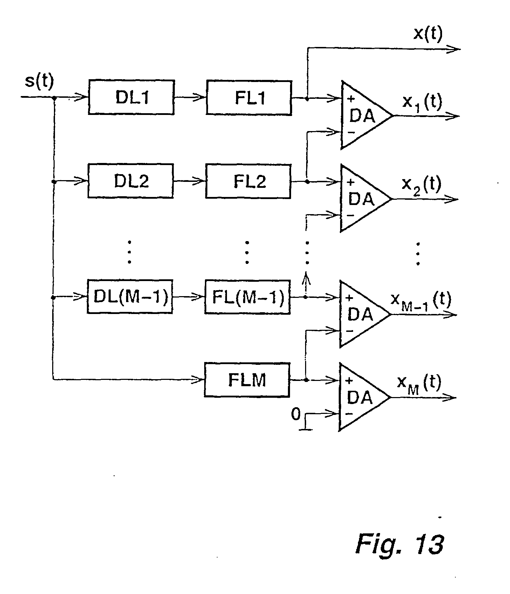

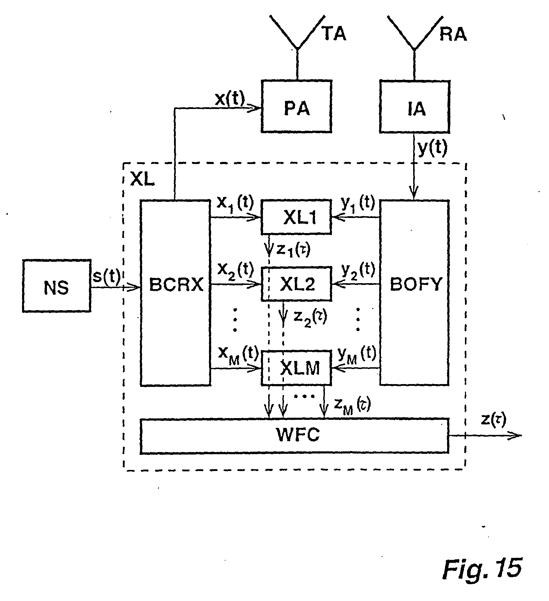

The system shown in Fig. 7 involves copying the transmitted signal to the binary component resolver BCRX. In an alternative system shown in Fig. 15, a noise signal s(t) is delivered to the binary component resolver BCRX, which not only splits the signal into components occupying different frequency bands, but also generates an interrogation signal x(t) which corresponds to a combination of those components. (Techniques for achieving this will be described below with reference to Figs. 12 and 13.) Accordingly, the decomposed received signal will more closely match the decomposed version of the transmitted signal.

The arrangement of Fig. 15 generates the interrogation signal x(t) and then transmits it via the antenna TA. As an alternative, the separate components x₁(t), x₂(t), ... could be transmitted via a plurality of antennas, e.g. one for each component. The single interrogation signal x(t) is thus created by the simultaneous presence of the transmitted components. Additionally, or alternatively, the single receiving antenna could be replaced by a plurality of antennas for receiving different frequency bands. These alternatives are particularly useful where it is difficult or expensive to make a wideband antenna of suitable characteristics.

The basic bank of filters with rectangular responses is of limited practical application for two reasons:
- the frequency spectrum of a wideband random signal x(t) suitable for ranging purposes will have a shape substantially different from a rectangular one; the spectrum will decay monotonically and rather slowly (not abruptly) at higher frequencies. Where a copy of the transmitted signal is provided to the bank of filters, it would be desirable for the collective response characteristics of the filters to correspond, at least substantially, to the spectrum of the transmitted signal, to improve the signal-to-noise ratio, and for other reasons. Where the transmitted signal is derived by summing the outputs of the filters, it would be desirable for the collective response characteristics of the filters to match the desired spectrum so that the transmitted signal is of a suitable form;
- it is difficult to construct a filter with a rectangular power transfer function |H(f)|².

Therefore, it is of interest to examine the relationship between the number of degrees of freedom and the number of zero crossings observed in a wideband random signal x(t) with its power spectral density Sₓ(f) shaped suitably for ranging purposes. A brief analysis is presented in the example below.

### Example 2

Assume that a wideband zero-mean random signal x(t) employed to interrogate a surveillance region has a Gaussian distribution and that the power spectral density Sₓ(f) of x(t) has a Gaussian shape 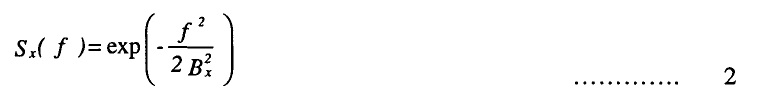 where Bₓ is the root-mean-square (rms) bandwidth of the random signal x(t). For a signal with a Gaussian spectrum, the commonly used 3dB-bandwidth B_{3dB} can be determined from the rms bandwidth Bₓ as follows${\text{B}}_{\text{3dB}} \text{=} {\text{B}}_{\text{x}} \sqrt{\text{2} \text{ln} \text{2}} \text{≈} {\text{1.177 B}}_{\text{x}}$

From Rice's formula it follows that, on average, N₀(T) = 2BₓT zero crossings can be extracted from the random signal x(t) during a time interval T.

Let a received signal y(t) contain a signal n(t) representing unwanted noise and other interference to be suppressed in the receiver; the power spectral density Sₙ(f) of n(t) will have the same Gaussian shape as that of the interrogating random signal x(t). The number of degrees of freedom Λ, hence the maximum achievable processing gain, can be determined from 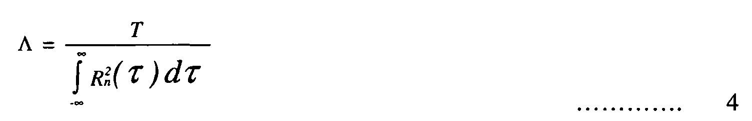 where Rₙ(τ) is the normalised autocorrelation function of n(t), i.e., Rₙ(0) = 1. Consequently, the maximum achievable processing gain is$\text{Λ =} \text{2} \sqrt{\text{π}} {\text{B}}_{\text{x}} \text{T} \text{=} \sqrt{\frac{\text{2π}}{\text{ln} \text{2}}} {\text{B}}_{\text{3dB}} \text{T}$

Hence, Λ>N₀(T)=2BₓT. Because, in crosslation-based signal processing, each zero crossing determines exactly one segment of a received signal y(t) to be averaged, the maximum processing gain cannot be attained.

In fact, because N₀(T) ≈ 0.56 Λ, the sampling scheme based on zero-crossings determines only about 56% of segments required for optimum interference suppression via averaging. Hence, the use of an interrogating random signal x(t) in conjunction with a basic crosslation method will result in a detection performance which is less than optimum.

In order to facilitate the understanding of the operational principles of a bank of filters constructed in accordance with a preferred embodiment of the invention, it is convenient (although not necessary) to assume first that the spectral density Sₓ(f) of a primary random signal x(t) to be decomposed has a Gaussian shape, as discussed in Example 2 above.

To make the number of degrees of freedom equal to the number of zero crossings observed in a first component random signal x₁(t), the required power spectral density Sₓ₁(f) of x₁(t) can be obtained by forming a difference between the primary density Sₓ(f) of x(t) and its frequency-scaled version S_{xα}(f), where 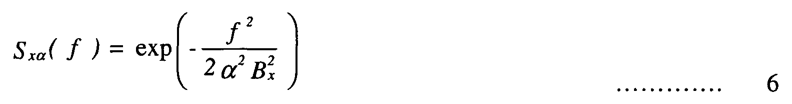 and α ≈ 0.325 (the derivation of the value α is set out below).

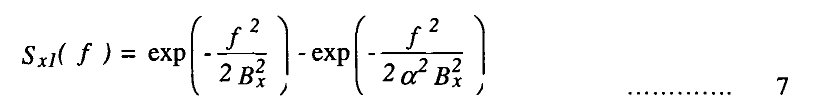

In this case, the ratio of the bandwidth of the primary Gaussian spectral density Sₓ(f) to that of the Gaussian density S_{xα}(f) is equal to 1/α ≈ 3.08. It should be noted that in the considered Example 1 of rectangular frequency spectra, a similar ratio was equal approximately to 3.19.

For a Gaussian spectral density in the frequency band (W₁, W₂), the number M of required filters will be:

**Table 2**

| R_{UL} | M |
|---|---|
| R_{UL}≤ 3.08 | 1 |
| 3.08 < R_{UL} ≤ 9.47 | 2 |
| 9.47 < R_{UL} ≤ 29.13 | 3 |

where, again, R_{UL} = W₂ / W₁.

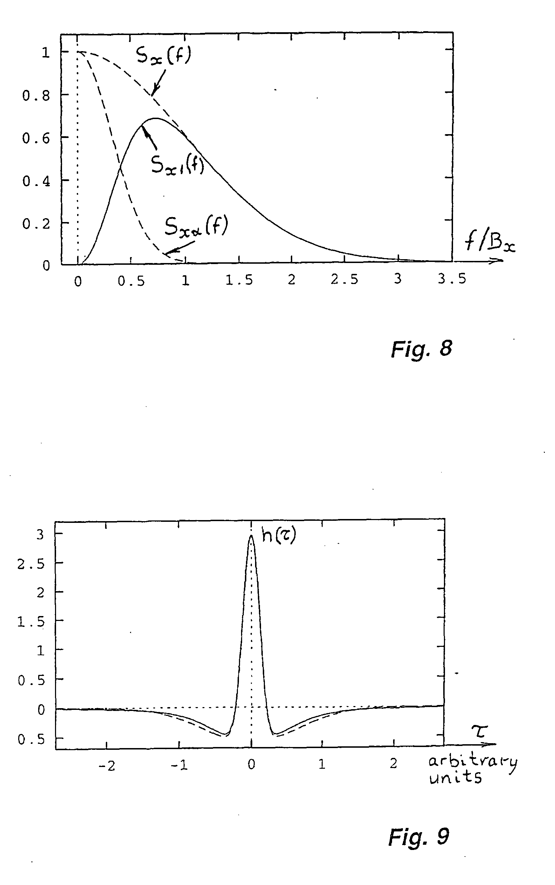

Fig. 8 depicts the required power spectral density Sₓ₁(f) (shown in solid line) obtained by subtracting the frequency-scaled Gaussian spectrum S_{xα}(f) from the primary Gaussian spectrum Sₓ(f) (both shown in broken lines).

In principle, a component random signal x₁(t) with the required spectrum Sₓ₁(f) may be obtained by passing a wideband random signal through a bandpass filter with the following transfer function${\text{H}}_{\text{1}} \text{( f )} \text{=} \sqrt{{\text{S}}_{\text{x1}} \text{( f )}} \text{exp [-} \text{jθ( f )} \text{]}$ where θ(f) is an arbitrary realizable phase characteristic. In the case of a linear phase characteristic (or when θ(f)=0), the impulse response h₁(τ) of the filter F1 will assume the form shown in solid line in Fig. 9. However, a filter specified by the required transfer function H₁(f) or, equivalently, by the impulse response h₁(τ), may be difficult to implement in practice.

In accordance with a further preferred aspect of the invention, a primary wideband random signal x(t) with a suitable shape (not necessarily Gaussian) of its spectrum Sₓ(f) is decomposed into a plurality of component random signals with the use of a filter bank comprising only low-pass filters with substantially constant group delays and overlapping transfer functions.

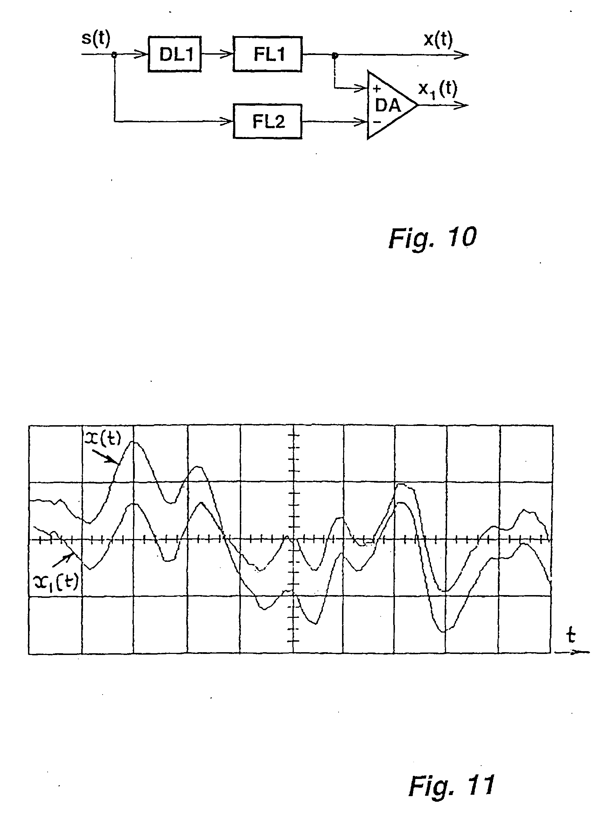

Fig. 10 depicts a block diagram of a basic bandpass cell of a bank of filters arranged to operate in accordance with the present invention. The cell comprises two low-pass filters FL1 and FL2, each with a suitably chosen bandwidth (that of filter FL1 being greater than that of FL2) and a substantially constant group delay, a constant delay DL1, and a wideband differential amplifier DA.

The two low-pass filters, FL1 and FL2, may be of commercially available types (such as Bessel, Bessel-Thomson, or quasi-Gaussian) used for data transmission applications (e.g., in SONET or SDH systems). In general, a filter FL2 with a narrower bandwidth will have a greater group delay than that of a filter FL1 with a broader bandwidth. Therefore, the delays experienced by an input signal s(t) in the two channels are made equal by incorporating a suitably chosen delay DL1 into a channel containing the filter FL1. The value of this delay is equal to the difference in the respective group delays. Consequently, the resulting impulse response, shown in broken line in Fig. 9, can approximate the required impulse response, shown in solid line.

Fig. 11 shows examples of a primary wideband random signal x(t) and a resulting bandpass component random signal x₁(t) obtained experimentally by applying a wideband noise signal s(t) to the basic bandpass cell (Fig. 10), constructed in accordance with the invention. The cell comprised two low-pass filters with constant group delays and the 3-dB bandwidths of 117 MHz and 39 MHz, respectively. The value of the constant delay DL1 was equal to 5 ns. As seen, the resulting bandpass component signal x₁(t) exhibits more zero crossings than does the primary wideband signal x(t).

For any types of low-pass filters, FL1 and FL2, with constant group delays, the following procedure can be used to determine the required bandwidth of the filter FL2 and to select the required delay of DL1:
1. for a selected filter FL1, use its frequency characteristic, provided by the manufacturer, to determine numerically the number of degrees of freedom Λ₁ (in time T) associated with that characteristic (e.g., by applying the method described in Example 2);
2. determine experimentally the group delay of FL1 (e.g., by examining its response to a unit step function);
3. select a filter FL2 (not necessarily of the same type as FL1) with a 3dB-bandwidth equal approximately to 1/3 of that of FL1;
4. determine numerically the number of degrees of freedom Λ₂ (in time T), for the filter FL2;
5. determine experimentally the group delay of FL2 and calculate the required delay value of DL1 from the difference in the group delays of FL1 and FL2;
6. determine experimentally the number N₀ₓ₁(T) of zero crossings observed in time T in the resulting bandpass component signal x₁(t);
7. if N₀ₓ₁(T) ≈ (Λ₁- Λ₂), terminate the procedure;
8. if N₀ₓ₁(T) > (Λ₁- Λ₂), decrease the bandwidth of FL2, and if N₀ₓ₁(T) < (Λ₁- Λ₂), increase the bandwidth of FL2 (by altering the characteristics of FL2 or choosing a different filter to use as FL2);
9. go to step 4.

When filter FL2 is of the same type as filter FL1, Step 4 will exploit the relationship, already established in Step 1, between the bandwidth and the number of degrees of freedom to determine the value of Λ₂. This relationship will also be used when Step 4 is repeated to find new values of Λ₂.

When filter FL2 is not of the same type as filter FL1, Step 4 will establish the required relationship between the bandwidth and the number of degrees of freedom for the type of selected filter FL2; the value of Λ₂ will then be determined. When Step 4 is repeated, the same relationship will be used to determine new values of Λ₂.

The above procedure, in a suitably modified form, can also be used to determine the required parameters of the basic bandpass cell by computer analyses and simulations. In such a case, Steps 2 and 5 are omitted, and the number of zero crossings to be determined in Step 6 can be obtained numerically from the value of the rms bandwidth of the resulting spectrum.

Such techniques for designing a bank of filters, and means (such as a computer program) employing such techniques, are regarded as being independently inventive.

Fig. 12 depicts a block diagram of a bank of filters BOF comprising a plurality of basic bandpass cells, arranged to operate in accordance with the present invention. The system has an iterated structure comprising (M+1) low-pass filters, FL1, FL2, ... FL(M+1), with suitably chosen bandwidth, M constant delays, DL1, DL2, ... ,DLM, M identical differential amplifiers DA, and a summing amplifier SAM. The value of the constant delay DLm preceding each low-pass filter FLm, except for filter FL(M+1), is so selected as to obtain the maxima of the impulse responses of all the resulting (M+1) channels to coincide at the same time instant. In the application shown, the bank of filters is driven by a wideband noise signal s(t), and a primary wideband random signal x(t) with a required bandpass spectrum is obtained by summing the component signals, x₁(t), x₂(t), ... , x_{M}(t) in a suitable summing amplifier SAM, after which the signal x(t) is transmitted as an interrogation signal.

As mentioned above, the component signals could be transmitted by multiple antennas, in which case the block SAM would represent the antennas, the signal x(t) being created by the simultaneous transmission of the respective components. Alternatively, some components could be summed together to form component sets which are then transmitted by separate antennas.

Fig. 13 depicts a block diagram of a modified bank of filters comprising a plurality of basic bandpass cells, arranged to operate in accordance with the present invention. In this application, the bank of filters is also driven by a wideband noise signal s(t), but the primary wideband random signal x(t) with a required *low-pass* spectrum is obtained at the output of a low-pass filter FL1 used in channel 1. It should be noted that, by design, the sum of the component signals, x₁(t), x₂(t), ... , x_{M}(t), forms a replica of the signal x(t), delayed by the value introduced by the differential amplifier DA. The system configuration differs from that shown in Fig. 12 as follows:
- no summing amplifier is needed;
- only M low-pass filters are used;
- only (M-1) constant delays are required.

Either of the two banks of filters described above can be exploited to construct a suitable binary component resolver BCRX to be utilized in conjunction with the underlying bank of filters BOFY in an improved crosslator XL, employed by the object detecting system shown in Fig. 7 or Fig. 15.

Although the decomposition techniques of the present invention have been described in the context of object detection systems using crosslation, other applications also exist. The techniques are of particular value for facilitating analysis of signals, for example by deriving therefrom significant events such as zero-crossings, and for comparing two signals, one of which may be a time-delayed version of the other. In the latter case, it is not essential that crosslation techniques be used; instead other techniques, known *per se,* could be employed, e.g. correlation, such as polarity-coincidence correlation.

The invention is of particular value when applied to chaotic random signals. However, the invention can also be applied to other signals, such as noise-like signals, or deterministic signals (which are preferably at least substantially aperiodic during time periods of interest), and the term "random" is intended to encompass such irregular signals.

The foregoing description of preferred embodiments of the invention has been presented for the purpose of illustration and description. It is not intended to be exhaustive or to limit the invention to the precise form disclosed. In light of the foregoing description, it is evident that many alterations, modifications, and variations will enable those skilled in the art to utilize the invention in various embodiments suited to the particular use contemplated.

The derivation of a suitable value of α (see formula 6) representing the frequency scaling is as follows.

Let x(t) be a stationary zero-mean random Gaussian signal with the power spectral density (psd) Sₓ(*f*) of the Gaussian form 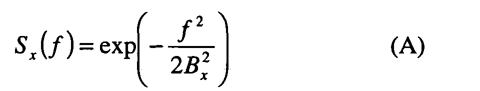 where Bₓ is the root-mean-square (rms) bandwidth defined by

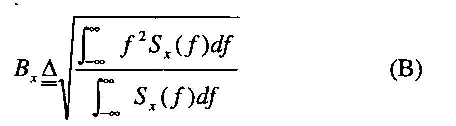

In the case of a random Gaussian signal x(t), the number N₀(T) of all zero crossings (i.e. upcrossings and downcrossings) occurring in a time interval T is given by Rice's formula${\text{N}}_{\text{0}} {\text{(T) = 2B}}_{\text{x}} \text{T}$ where Bₓ is the rms bandwidth of the signal.

The number of *degrees of freedom* Λ, characterizing a segment of a random Gaussian signal x(t), can be determined from 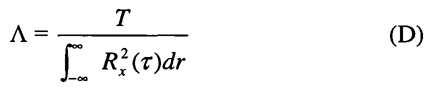 where T is the duration of the segment, and Rₓ(τ) is the normalised autocorrelation function of x(t), i.e. Rₓ(0) = 1.

The normalised autocorrelation function Rₓ(τ) of a signal x(t) with the psd (A) is of the form${\text{R}}_{\text{x}} {\text{(τ) = exp(-2π}}^{\text{2}} {\text{B}}_{\text{x}}^{\text{2}} {\text{τ}}^{\text{2}} \text{)}$

Therefore, the number of degrees of freedom A contained in a segment T of x(t) is given by$\text{Λ = 2} \sqrt{\text{π}} {\text{B}}_{\text{x}} \text{T}$

As seen from (C) and (F), because N₀(T) < Λ, zero crossings of a random Gaussian signal x(t) with the psd (A), observed over interval T, cannot possibly fully represent that signal segment.

Consider a random Gaussian signal x₁(t) with the following psd${\text{S}}_{\text{x} \text{1}} \text{(} \text{f} \text{) =} {\text{S}}_{\text{x}} \text{(} \text{f} \text{) -} {\text{S}}_{\text{xα}} \text{(} \text{f} \text{)}$ where

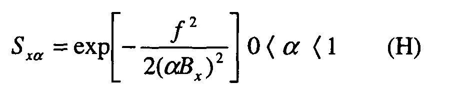

This specific form of (G) has been obtained by subtracting from (A) its frequency-scaled version (H). Consequently, the resulting psd (G) has a distinct bandpass characteristic. The shapes of the above psds are shown in Fig. 8.

Since both the spectral components of (G) have Gaussian shapes, the number of degrees of freedom Λ₁ associated with a segment T of a signal x₁(t) with the psd (G) can be expressed as${\text{Λ}}_{\text{1}} \text{= 2} \sqrt{\text{π}} {\text{B}}_{\text{x}} \text{T} \text{(1-α)}$

The rms bandwidth Bₓ₁ of x₁(t) with the psd (G) can be determined from (B); hence${\text{B}}_{\text{x} \text{1}} \text{=} {\text{B}}_{\text{x}} \sqrt{{\text{1 + α + α}}^{\text{2}}}$

Consequently, the number N₀₁ of zero crossings occurring in a segment T of x₁(t) is given by${\text{N}}_{\text{01}} \text{(} \text{T} \text{) = 2} {\text{B}}_{\text{x}} \text{T} \sqrt{{\text{1 + α + α}}^{\text{2}}}$

As seen from (I) and (K), the ratio$\frac{{\text{N}}_{\text{01}} \text{(} \text{T} \text{)}}{{\text{Λ}}_{\text{1}}} \text{=} \frac{\sqrt{{\text{1 + α + α}}^{\text{2}}}}{\sqrt{\text{π}} \text{(1 - α)}}$ increases from 1/^{√π} , for α = 0, to infinity for α approaching one.

When N₀₁(T) > Λ₁, a signal is said to be *overdetermined* by its zero crossings; similarly, when N₀₁(T) < Λ₁, a signal is *underdetermined* by its zero crossings. Therefore, it is of both theoretical and practical interest to calculate this specific value α* of a α for which N₀₁(T) = Λ₁.

The value α* is a solution to the equation 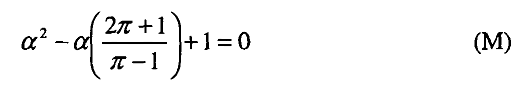 which satisfies the condition 0 < α* < 1; hence 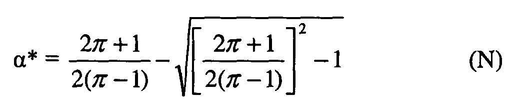 and α* ≈0.325.

Therefore, a random Gaussian signal x₁(t) with the following *bandpass* psd 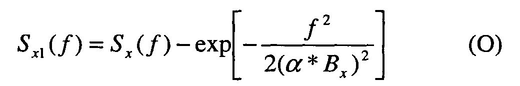 will have a necessary number of zero crossings for its representation in the sense that, for any specified time interval T, the number of zero crossings observed in T will be equal to the number of degrees of freedom associated with that interval.

This analysis is applicable to a random signal with a Gaussian probability density function and a Gaussian power spectral density (psd), and can be modified to include a random Gaussian signal with a psd having the shape different from a Gaussian form. It is believed that the value α (0.3139 for uniform psd and 0.325 for Gaussian psd) is unlikely to be significantly different for other types of signals of practical interest, and consequently a high/low frequency ratio of approximately 3:1 is likely to produce efficient results for all such signals.

## Claims

1. A method of determining the amount by which one wideband signal is delayed with respect to another wideband signal, the method comprising analysing the signals in respective different frequency bands, and within each band deriving from a first of the signals events occurring at non-uniform intervals, using each event to define a segment of the second signal and forming a representation of a combination of the segments, the method including the further step of combining the representations and determining the delay amount from the position within the combined representations of a feature derived from combining parts of the second signal associated with the respective events derived from the first signal.

2. A method as claimed in claim 1, wherein the first signal is filtered to enable analysis in the respective frequency bands.

3. A method as claimed in claim 1, wherein the first signal is derived by filtering a source signal to obtain components in the respective frequency bands and combining said components.

4. A method as claimed in any preceding claim, wherein within each frequency band the ratio of the highest frequency to the lowest frequency is at least 2.5:1.

5. A method as claimed in any preceding claim, wherein within each frequency band the ratio of the highest frequency to the lowest frequency is no greater than 3.5:1.

6. Apparatus for determining the delay between two corresponding signals, the apparatus being arranged to operate according to a method as claimed in any preceding claim.

7. Obstacle detection apparatus comprising a device for measuring the delay between a transmitted signal and its reflection, the device being arranged to operate in accordance with a method as claimed in any one of claims 1 to 5, and means for deriving from the delay an indication of the distance of an object from which the transmitted signal is reflected.

8. Apparatus as claimed in claim 7, wherein the transmitted signal is said first signal.

9. Apparatus for decomposing a wideband random signal, the apparatus comprising a plurality of channels each for receiving the signal and each operable to impart a delay to the signal, to low-pass filter the signal and to provide a channel output which subtracts from the low-pass delayed signal the corresponding signal from the channel with the next lower filter cut-off frequency characteristic, the delay circuit characteristics in the respective channels being such that the delay and low-pass filtering effectively provide substantially the same total delay in each channel.

10. Apparatus as claimed in claim 9, wherein the ratio of the highest frequency to the lowest frequency in each channel output is at least 2.5:1.

11. Apparatus as claimed in claim 9 or 10, wherein the ratio of the highest frequency to the lowest frequency in each channel output is no greater than 3.5:1.

12. Apparatus for decomposing and representing a wideband signal, the apparatus including a decomposing apparatus as claimed in any one of claims 9 to 11, and means for combining the channel outputs in order to provide a representation of a wideband signal.

13. Object detection apparatus comprising apparatus as claimed in claim 12, means for transmitting the representation, means for detecting and decomposing the reflection of the transmitted representation, and means for detecting an object by combining each channel output with a respective decomposed component of the detected reflection.

14. Apparatus for analysing a wideband random signal, the apparatus comprising means for separating the signal into components occupying different frequency bands, and, within each frequency band, detecting zero-crossings in the respective components, wherein, within each frequency band, the ratio of the highest frequency to the lowest frequency is from 2.5:1 to 3.5:1.

15. Apparatus as claimed in claim 14, wherein said ratio is greater than or equal to 3.0: 1.

16. A method of detecting an object, the method comprising providing a wideband random signal, decomposing the signal into components occupying respective frequency bands, transmitting an interrogation signal which corresponds to a combination of the components, receiving a reflection of the interrogation signal, decomposing the reflection into respective frequency bands, separately comparing the components of the wideband signal with the respective components of the reflection and combining the results of the comparisons.

17. A method as claimed in claim 16, including the step of deriving the interrogation signal such that it corresponds to the combination of the components before the step of transmitting the interrogation signal..

18. A method as claimed in claim 16, wherein the step of transmitting the interrogation signal comprises using multiple antennas to transmit components occupying respective frequency ranges.

19. A method as claimed in any one of claims 16 to 18, wherein the step of receiving the reflection of the interrogation signal comprises using multiple antennas to receive components occupying respective frequency ranges.

20. A method of producing a decomposing apparatus as claimed in any one of claims 9 to 11, the method comprising:
1. for a first filter in a first channel, determining the number of degrees of freedom, in a predetermined time, associated with the frequency characteristic of the first filter;
2. determining the group delay of the first filter;
3. selecting a second filter for a second channel, the second channel having the next lower filter cut-off frequency characteristic as compared with the first channel, and the second filter having a bandwidth substantially smaller than that of the first filter;
4. determining the number of degrees of freedom, in a predetermined time, associated with the frequency characteristic of the second filter;
5. determining the group delay of the second filter and calculating a required delay value for the second channel from the difference in the group delays of the first and second filters;
6. determining the number of zero crossings, in a predetermined time, observed in the bandpass component signal output from the first filter; and
7. adjusting the bandwidth of the second filter, or replacing the second filter with a filter of different bandwidth, until the determined number of zero crossings is substantially equal to the difference between the determined numbers of degrees of freedom.
